# EUROPÄISCHE PATENTSCHRIFT

(11) **EP 0 474 086 B1**
(45) Veröffentlichungstag und Bekanntmachung des Hinweises auf die Patenterteilung: **11.12.1996**
(21) Anmeldenummer: 91114284.2
(22) Anmeldetag: 26.08.1991
(51) Int. Cl.: G01R 15/12

(54) **Multimeter mit mindestens drei Eingangsanschlüssen**
Multimeter having at least three input connections
Contrôleur universel ayant au moins trois raccords d'entrée

(30) Priorität: 01.09.1990 DE 4027801
(43) Veröffentlichungstag der Anmeldung: 11.03.1992
(73) Patentinhaber: Gossen- Metrawatt GmbH, D-8500 Nürnberg (DE)
(72) Erfinder: Hochreuther, Karl, W-8500 Nürnberg (DE); Roppelt, Günter, W-8500 Nürnberg 60 (DE); Ziegler, Herbert, W-8500 Nürnberg 90 (DE); Kindermann, Robert, W-8500 Nürnberg 90 (DE); Hopfner, Horst, W-8501 Rückersdorf (DE)
(74) Vertreter: Hafner, Dieter, Dr.rer.nat., Dipl.-Phys.

(56) Entgegenhaltungen:
- DE-B- 1 466 640

## Beschreibung

Die Erfindung betrifft ein Multimeter der im Oberbegriff des Anspruchs 1 genannten Art.

Multimeter sind die Universalisten unter den Meßgeräten und erfreuen sich wegen ihrer vielseitigen Anwendbarkeit in Laboratorien und Werkstätten aber auch bei Bastlern großer Beliebtheit. Das Spektrum der Meßgrößen, das von vielen dieser Geräte abgedeckt wird, reicht von Spannungen über Ströme, Widerstände, Pegel bis zu Frequenzen, um nur einige zu nennen. Die Meßschaltungen, die zur Erfassung der verschiedenen Meßgrößen benötigt werden, unterscheiden sich zum Teil ganz erheblich, was bedeutet, daß für die unterschiedlichen Meßgrößen auch unterschiedliche Eingangskreise für die Messung zur Verfügung stehen müssen.

Die Vielseitigkeit der Multimeter birgt allerdings auch Gefahren. So ist es wichtig, daß vor jeder Messung der richtige, der zu untersuchenden Meßgröße zugeordnete Eingangskreis angeschlossen wird. Soll z.B. die Netzspannung gemessen werden und bleibt versehentlich der Eingangskreis eingeschaltet, der zur Messung von Strömen vorgesehen ist, so kann das für das Multimeter, bisweilen sogar für den Bedienenden, schwerwiegende Folgen haben, wenn die Netzsicherung nicht schnell genug abschaltet. Die im Multimeter vorgesehene Gerätesicherung reicht in aller Pegel nicht aus, um das Multimeter von eier energiereichen Spannungsgquelle zu trennen, da der beim Öffnen des Stromkreises auftretende Lichtbogen die Gerätesicherung überbrückt.

Ähnliche Probleme und Gefahren können auch bei anderen Kombinationen, bei denen eine Meßgröße auf einen falschen Eingangskreis trifft, für das Meßobjekt, das Multimeter und den Bedienenden entstehen. Doch selbst dann, wenn aus einem Bedienungsfehler keine unmittelbare Gefahr resultiert, kann es immer noch zu einer mittelbaren Gefährdung kommen, wenn z.B. die Anzeige des Multimeters das Fehlen einer zu prüfenden Spannung vortäuscht, weil ein Eingangskreis angeschlossen wurde, der gerade außer Betrieb, also nicht mit dem Meßsystem verbunden war. Durch die vorgetäuschte Spannungsfreiheit wird der Bedienende bisweilen zu ihn gefährdenden Handlungen verleitet.

Worauf zu achten ist, damit es bei einem Multimeter nicht zu derartigen Fehlbedienungen kommt, hängt vom Aufbau dieses Gerätes ab. Bei vielen Multimetern besitzen die verschiedenen Eingangskreise einen allen Eingangskreisen gemeinsamen ersten Eingangsanschluß und einen eigenen dem jeweiligen Meßkreis zugeordneten mit der zugehörigen Meßgröße korrespondierenden zweiten Eingangsanschluß. In der Regel gehören zu jeder Meßgröße wiederum mehrere Meßbereiche z.B. zur Meßgröße "Spannung" die Meßbereiche 1, 3, 10, 30V usw. Der Eingangskreis besitzt in diesem Fall einen Spannungsteiler, an dem alle Spannungen auf Werte herabgeteilt oder auch durch Verstärkung erhöht werden, damit an das Meßsystem angepaßte Werte zur Verfügung stehen.

Für das Umschalten des Spannungsteilers auf einen gewünschten Spannungsmeßbereich bzw. das Umschalten von Shunts auf einen gewünschten Strommeßbereich verwendet man einen Meßbereichsschalter. Bei der Bedienung des Meßgerätes muß man also dafür sorgen, daß der Meßbereichsschalter auf die Meßgröße gestellt wird, die gemessen werden soll. Gleichzeitig ist aber darauf zu achten, daß eingangsseitig am Multimeter die Meßleitungen mit den richtigen Eingangsanschlüssen und dadurch mit dem richtigen Eingangskreis verbunden werden.

Es liegt auf der Hand, daß bei weniger konzentriertem Arbeiten, besonders auch durch Nichtfachleute, einer der beiden Bedienhandgriffe vergessen werden kann und dann entweder der falsche Eingangskreis angeschlossen, oder ein falscher Meßbereich eingeschaltet wird.

Selbstverständlich hat man versucht mit zusätzlichen Sicherungsmaßnahmen die Gefahren einer Fehlbedienung in Grenzen zu halten. Die verwendeten Schutzschaltungen arbeiten mit passiven und aktiven Relaisschaltern, gesteuerten Halbleiterschaltern, mit Transistoren und Thyristoren sowie Schmelzsicherungen besonderer Bauart. Trotz des teilweise recht hohen Aufwandes gelingt es mit bisherigen Techniken jedoch keineswegs immer, leistungsstarke Spannungsquellen innerhalb des kleinen, bei modernen Multimetern zur Verfügung stehenden Raumes im Fehlerfall sicher abzuschalten. Eine Verminderung der Gefahren läßt sich somit nur erzielen, wenn die Fehlbedienung weitgehend ausgeschlossen wird.

Es wurde versucht diese Aufgabe dadurch zu lösen, daß man das Umstecken der Meßleitungen durch Umschalten der Eingangskreise ersetzte. Hierdurch wurde zwar die Bedienung des Meßgerätes etwas erleichtert, aber das Problem nicht beseitigt. So kann das Umschalten der Eingangskreise entweder durch einen zusätzlichen Eingangskreisschalter geschehen oder durch den Meßbereichsschalter zusätzlich übernommen werden. Ein zusätzlicher Eingangskreisschalter verlagert das Problem lediglich auf ein anderes Bauteil, da nun mit gleicher Aufmerksamkeit darauf geachtet werden muß, daß sowohl der Eingangskreisschalter als auch der Meßbereichsschalter auf die zu untersuchende Meßgröße gestellt wurden. Demgegenüber bedeutet eine Zusammenfassung aller Schaltfunktionen am Meßbereichsschalter, daß dieser in der Lage sein muß außer sehr kleinen auch große Leistungen zu schalten, was wiederum eine erhebliche Verteuerung dieses Bauelements zu Folge hat. Außerdem ist zu bedenken, daß die hierdurch erreichte Verminderung der Zahl der Bedienelemente nicht zwangsläufig die Bedienung wesentlich sicherer macht, denn auch ein einziger Schalter kann immer noch in eine falsche Schaltstellung gebracht werden, was dann zwangsläufig zum Anschluß auch eines falschen Eingangskreises mit entsprechenden Folgen führt. Insofern kann der Zwang auf die richtige Stellung von zwei Bedienelementen achten zu müssen, zu einer erhöhten Aufmerksamkeit führen.

Aufgabe der Erfindung ist es, ein Multimeter nach dem Oberbegriff des Anspruchs 1 zu schaffen, das mit einem Meßbereichsschalter auskommt, der nur sehr kleine Leistungen zur Weitergabe an das Meßsystem schalten muß, den Bedienenden jedoch daran hindert einen solchen Eingangskreis anzuschließen, der einer Meßgröße zugeordnet ist, die nicht am Meßbereichsschalter eingestellt wurde.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Da erfindungsgemäß eine Sperrvorrichtung mit der jeweiligen Schaltstellung des Meßbereichsschalters gekoppelt ist, gelingt es, die Eingangsanschlüsse gegenüber einer das Meßsignal aufnehmenden Kontaktierung so zu sperren, daß jeweils nur ein bestimmter Eingangsanschluß kontaktierbar ist. Die diesem Eingangsanschluß zugeordnete Meßgröße entspricht durch die Kopplung der am Meßbereichsschalter eingestellten Meßgröße. Die Kopplung mit dem Meßbereichsschalter kann sowohl auf mechanische als auch elektrische Weise erfolgen. In beiden Fällen wird der Benutzer davor geschützt, irrtümlich einen Eingangskreis für eine andere Meßgröße einzuschalten als auch am Meßbereichsschalter vorgegeben wurde, wodurch sich die Bedienungssicherheit des Meßgerätes wesentlich erhöht.

Eine besonders einfach aufgebaute Sperrvorrichtung läßt sich mit mechanischen Mitteln realisieren, wenn eine mit dem Meßbereichsschalter verbundene Sperrkulisse geschaffen wird, deren Lage sich bei Betätigung des Meßbereichsschalters bezüglich der Eingangsanschlüsse so ändert, daß sie eine Kontaktierung bestimmter Eingangsanschlüsse durch die vorzugsweise als Stecker ausgeführten Kontaktteile der Meßleitungen verhindert. Durch die starre Kopplung zwischen Meßbereichsschalter und Sperrkulisse wird insofern ein wesentlicher Sicherheitsgewinn erzielt, weil bei angeschlossenen Meßleitungen die eingesteckten Stecker die Sperrkulisse in ihrer Stellung fixieren und somit auch der Meßbereichsschalter durch die Kopplungselemente vor einem ungewollten Umschalten geschützt wird. Der Benutzer ist somit gezwungen, vor dem Umschalten auf eine andere Meßgröße den Stecker zu ziehen und dadurch die Sperrvorrichtung freizugeben. Durch die Öffnung des Eingangskreises ist gewährleistet, daß nur im spannungsfreien Zustand geschaltet werden kann, so daß keine die Schaltkontakte gefährdenden Ströme fließen. Nach erfolgter Umschaltung kann wiederum nur ein solcher Eingangsanschluß kontaktiert werden, dem eine mit dem Meßbereichsschalter vorgegebene Meßgröße zugeordnet ist.

Die Sperrkulisse wird man vorteilhaft aus einem isolierenden Kunststoff herstellen und so positionieren, daß sie den Aufnahmekanal mindestens eines der als Steckbuchsen ausgeführten Eingangsanschlüsse quer zur Steckrichtung blockieren kann. Für die Detailgestaltung einer mechanisch wirkenden Sperrvorrichtung gibt es beliebig viele Varianten, die hier nicht alle genannt werden können. Man wird die Sperrkulisse jeweils der Art und dem Aufbau des zugehörigen Meßbereichsschalters anpassen, so daß dementsprechend vorzugsweise eine Dreh- oder Schiebekulisse zur Anwendung kommt. In der Sperrkulisse sind Aussparungen vorzusehen, deren Positionierung mit der Schaltstellung des Meßbereichsschalters so korrespondiert, daß die Aussparungen jeweils den Aufnahmekanal des Eingangsanschlusses freigeben, der der mit dem Meßbereichsschalter eingestellten Meßgröße zugeordnet ist.

Weiterhin ist vorgesehen, die Sperrkulisse im Bereich der Eingangsanschlüsse in einer zu ihrer Aufnahme und Lagerung vorgesehenen Ausnehmung der Deckwand des Gehäuses beweglich anzuordnen. Ein von Hand betätigbares Betätigungsteil des Meßbereichsschalters kann dabei so auf die Sperrkulisse einwirken, daß diese ihre Lage zu den Eingangsanschlüssen entsprechend ändert.

Die Kopplung zwischen dem Meßbereichsschalter und der Sperrkulisse erfolgt zweckmäßigerweise dadurch, daß das Betätigungsteil des Meßbereichsschalters in der gleichen oder einer parallelliegenden Ebene, wie die als drebbewegliches Element ausgebildete Sperrkulisse angeordnet ist und Kupplungselemente für einen gegenseitigen Eingriff sorgen. Durch geeignete Maßnahmen kann man dafür sorgen, daß eine zwangsweise Mitnahme der Sperrkulisse nur in einem Teilbereich einer von einem Schalterelement ausführbaren Drehbewegung erfolgt.

Lösungen, bei denen nicht über den ganzen Drehbereich des Meßbereichsschalters eine starre Kupplung mit der Sperrkulisse erfolgt, haben den Sinn, auf verschiedene Meßbereiche der gleichen Meßgröße schalten zu können, ohne daß sich hierdurch an der Stellung der Sperrkulisse etwas ändert.

Ein am Betätigungsteil ausgebildetes Schalterrad besitzt mindestens einen Zahn, mit dem es an einem anderen Zahn der drehbeweglichen Sperrkulisse, vorzugsweise in die Nut einer zweizinkigen Gabel, wie bei einem Malteserkreuzgetriebe eingreifen kann.

Die zur Freigabe bestimmter Eingangsanschlüsse in der Sperrkulisse vorgesehene Aussparung muß so gestaltet sein, daß sie beim Umschalten mit der jeweiligen Lage des Eingangsanschlusses korrespondiert. Bei einer als drehbare Scheibe gestalteten Sperrkulisse kann die Aussparung ein rundes Loch sein, wenn die Eingangsanschlüsse auf einem entsprechenden Kreisbogen liegen. Liegen die Eingangsanschlüsse dagegen, wie üblich, auf einer Geraden, so ist die Aussparung als Langloch zu gestalten, um den bei der Drehung entstehenden Versatz auszugleichen.

An die Stelle einer einteiligen Sperrkulisse mit entsprechender Aussparung kann auch eine aus mehreren Sperrschiebern aufgebaute Sperrkulisse treten. Jeder dieser Sperrschieber ist dabei so zu lagern, daß er durch eine Verschiebung gegen die Kraft einer ihn in Ruhestellung haltenden Feder durch einen vom Meßbereichsschalter angetriebenen Nockenschieber in eine den Eingangsanschluß sperrende Stellung gebracht werden kann. Das Betätigungsteil des Meßbereichsschalters kann dabei durch eine Translation oder Rotation auf den Nokkenschieber wirken.

Eine elektrisch wirkende Sperrvorrichtung ist im Prinzip so aufzubauen, daß mindestens einer der vorzugsweise als Steckbuchsen ausgeführten Eingangsanschlüsse mit einem elektromagnetisch zu betätigenden Sperrelement versehen ist, das so angeordnet werden muß, daß es eine Kontaktierung verhindernde Sperrstellung annehmen kann. So wird z.B. der Aufnahmekanal einer Steckbuchse blockiert, wenn die am Meßbereichsschalter eingestellte Meßgröße mit der dem Eingangsanschluß zugeordneten Meßgröße nicht übereinstimmt. Hierbei ist wiederum eine Kopplung des elektromagnetisch betätigten Sperrelements mit dem Meßbereichsschalter erforderlich, die dadurch gelingt, daß ein Auslöseschaltkreis über eine Schaltstrecke des Meßbereichsschalters geführt wird.

Diese Aufgabe wird durch die in Anspruch 1 gekennzeichneten Merkmale gelöst. Zweckmäßige Ausgestaltungen und Weiterbildungen des Erfindungsgegenstandes sind in den Unteransprüchen genannt.

Es zeigen:
- Fig. 1: Multimeter in Draufsicht mit drehbarer Sperrkulisse
- Fig. 2: Multimeter nach Fig. 1 von der Seite, teilweise im Schnitt entlang der Schnittlinie I-I,
- Fig. 3: Schalterelement in Draufsicht,
- Fig. 4: Schalterelement seitlich im Schnitt,
- Fig. 5: drehbare Sperrkulisse in Draufsicht,
- Fig. 6: drehbare Sperrkulisse seitlich,
- Fig. 7: Sperrkulisse mit einzelnen Sperrschiebern,
- Fig. 8: Meßbereichsschalter als Schiebeschalter mit mehreren Sperrschiebern als Sperrkulisse
- Fig. 9: Meßbereichsschalter als Schiebeschalter mit einer einzelnen Sperrkulisse
- Fig. 10: Meßbereichsschalter mit elektromagnetischer Sperrvorrichtung,
- Fig. 11: Steckbuchse mit elektromagnetisch angetriebenem Sperriegel.

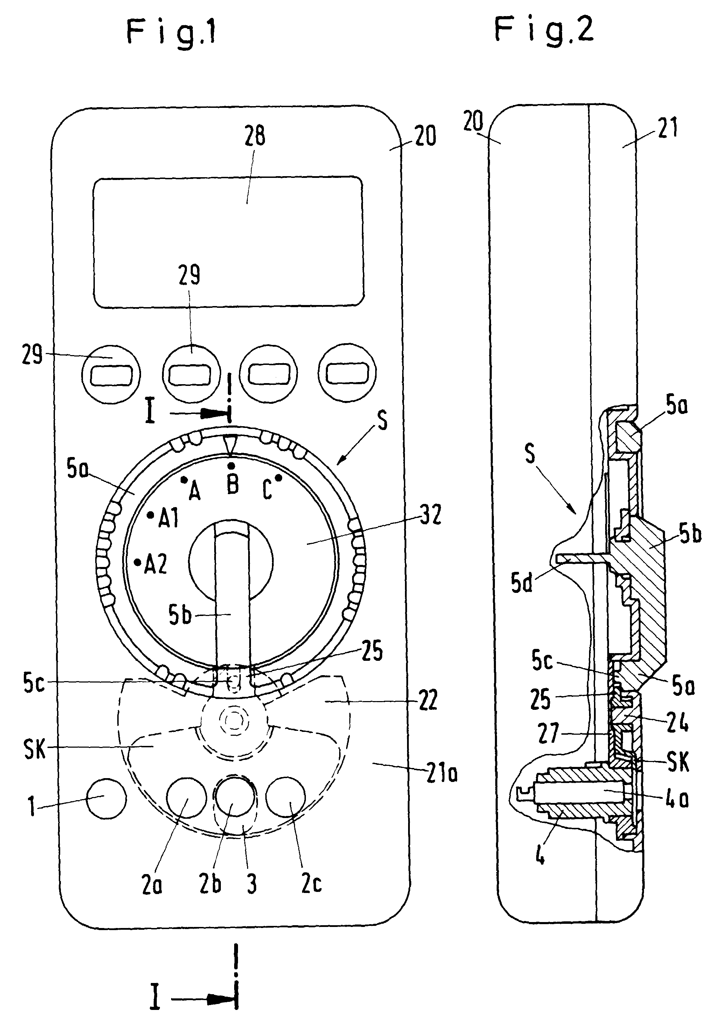

Von den verschiedenen Möglichkeiten, einen Meßbereichsschalter mit einer mechanisch wirkenden Sperrvorrichtung zu koppeln, ist eine erste Ausführungsvariante in den Fig. 1 und 2 im Detail dargestellt. Im Bereich einer Deckplatte 21a eines Multimetergehäuses 20 erkennt man eine Anzeige 28, mehrere Bedienelemente 29, einen Meßbereichsschalter S und Eingangsanschlüsse 1,2a bis 2c. Eine mit dem Meßbereichschalter S gekoppelte Sperrkulisse SK ist in Fig. 1 nur gestrichelt dargestellt, da sie sich in einer von außen nicht erkennbaren Ausnehmung 22 innerhalb der Deckwand 21a befindet.

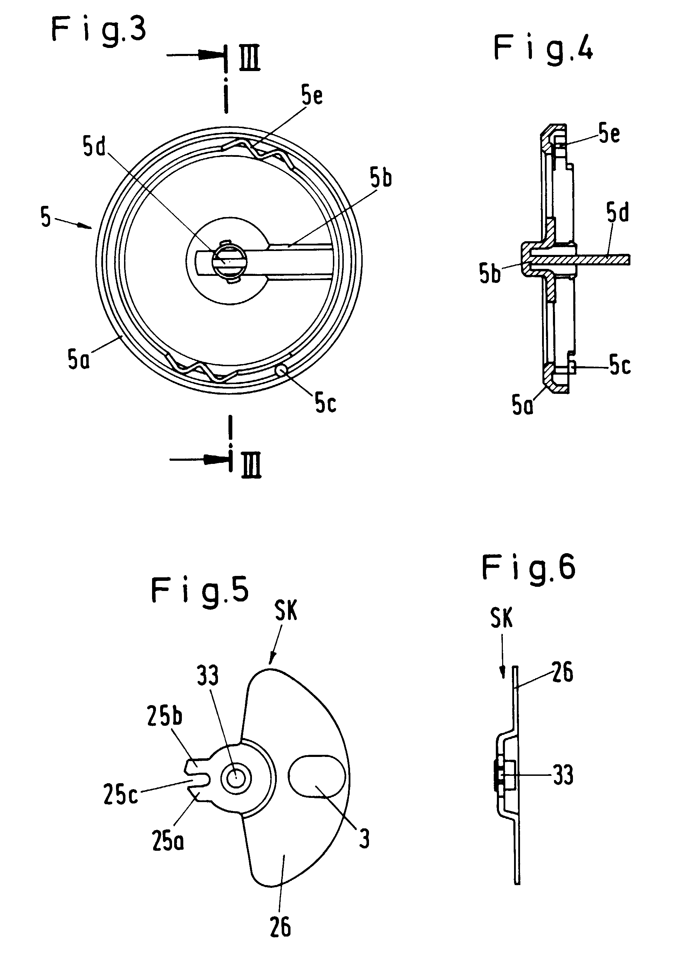

Weitere Einzelheiten des Meßbereichsschalters S, genauer gesagt seines Betätigungsteils 5, die auch für dessen Zusammenwirken mit der Sperrkulisse SK von Bedeutung sind, werden durch die Einzelteilzeichnungen Fig. 3 bis Fig. 6 verdeutlicht. Zu dem Betätigungsteil 5 des Meßbereichsschalters S gehören ein ringartig geformtes Schalterrad 5a, ein Schaltknebel 5b, ein als Zapfen ausgebildetes erstes Kupplungselement 5c und ein als Mitnehmer für die nicht dargestellten Kontaktträgerplatten des Meßbereichsschalters dienendes Schaltschwert 5d. Das Schaltschwert 5d ist mit dem Schalterrad 5a durch den als Steg wirkenden Schaltknebel 5b verbunden. Das am Schalterrad 5a angeformte zapfenartige erste Kupplungselement 5c ermöglicht an einem zweiten der Schaltkulisse SK zugehörigen zweiten Kupplungselement 25 einen die beiden Teile miteinander koppelnden Eingriff.

Die Kopplungsvorrichtung arbeitet nach Art eines einarmigen Malteserkreuzes mit einer zweizinkigen Gabel 25a,25b, die eine das zapfenartige erste Kupplungselement 5c aufnehmende Führungsnut 25c bilden. Wird bei einer Drehbetätigung des Schalterrades 5 ein vorgegebener Drehwinkel überschritten, so gleitet das zapfenartige erste Kupplungselement 5c aus der Führungsnut 25c heraus, und löst damit die starre Kopplung zwischen den beiden Teilen. In diesem Bereich ist es möglich, den Meßbereichsschalter S weiter zu drehen und gegebenenfalls auf andere, gewöhnlich zur gleichen Meßgröße gehörige Meßbereiche zu stellen, während die Sperrkulisse SK in ihrer Endstellung verharrt. Erst beim Zurückdrehen des Schalterrades 5a greifen das erste Kupplungselement 5c, bei Erreichen des zweiten Kupplungselementes 25 wieder in dieses ein und sorgt dafür, daß auch die Sperrkulisse SK mindestens bis zur nächsten Schaltstellung mitgenommen wird.

Im vorliegenden Beispiel nach Fig. 1 besitzt das Meßgerät 3 jeweils bestimmten Meßgrößen A,B,C zugeordnete Eingangsanschlüsse 2a,2b,2c und einen für alle drei Eingangsanschlüsse gemeinsamen Eingangsanschluß 1. Die Sperrkulisse SK besitzt eine Aussparung 3, die je nach Schaltstellung des Meßbereichsschalters S einen ganz bestimmten Eingangsanschluß 2a oder 2b oder 2c freigibt. Der Meßbereichsschalter S wurde auf die Meßgröße B eingestellt und in dieser Stellung gibt die Sperrkulisse SK nur den Eingangsanschluß 2b frei. Würde der Meßbereichsschalter S im Uhrzeigersinn auf die Meßgröße C weitergedreht, so würde sich die Sperrkulisse SK entsprechend verstellen und den Eingangsanschluß 2c freigeben. Die Aussparung 3 ist als Langloch geformt, damit der beim Drehen der Sperrkulisse SK entstehende Versatz gegenüber den auf einer geraden Linie angeordneten Eingangsanschlüssen 2a bis 2c ausgeglichen wird. Ordnet man die Eingangsanschlüsse 2a bis 2c so an, daß sie auf einem Kreisbogen zur Lagerstelle der Sperrkulisse SK liegen, so genügt eine kreisrunde Ausnehmung mit ausreichendem Durchmesser.

Die Lagerung der Sperrkulisse SK erfolgt durch einen auf der Innenseite der Deckwand 21a ausgebildeten Lagerzapfen 24, der in ein Lagerloch 33 der Sperrkulisse SK eingreift. Ebenfalls in der Deckwand 21a gelagert, aber von außen aufgesetzt, ist das Betätigungsteil 5. Ausgehend von der Ebene, in der die Kupplungselemente 5c, 25 liegen, verläuft die Sperrkulisse SK zu einer Sperrplatte 26, in der die Aussparung 3 liegt, so daß sie über die als Steckbuchsen 4 ausgebildeten Eingangsanschlüsse 2a,2b,2c hinweggleiten kann, und jeweils nur einen bestimmten Aufnahmekanal 4a freigibt. Zur Gehäuseinnenseite hin ist die Sperrkulisse noch die Aussparung 22 abdeckende Abdeckung 27 geschützt. Die Aussparung 22 ist nach Größe und Drehwinkel der Sperrkulisse SK bemessen.

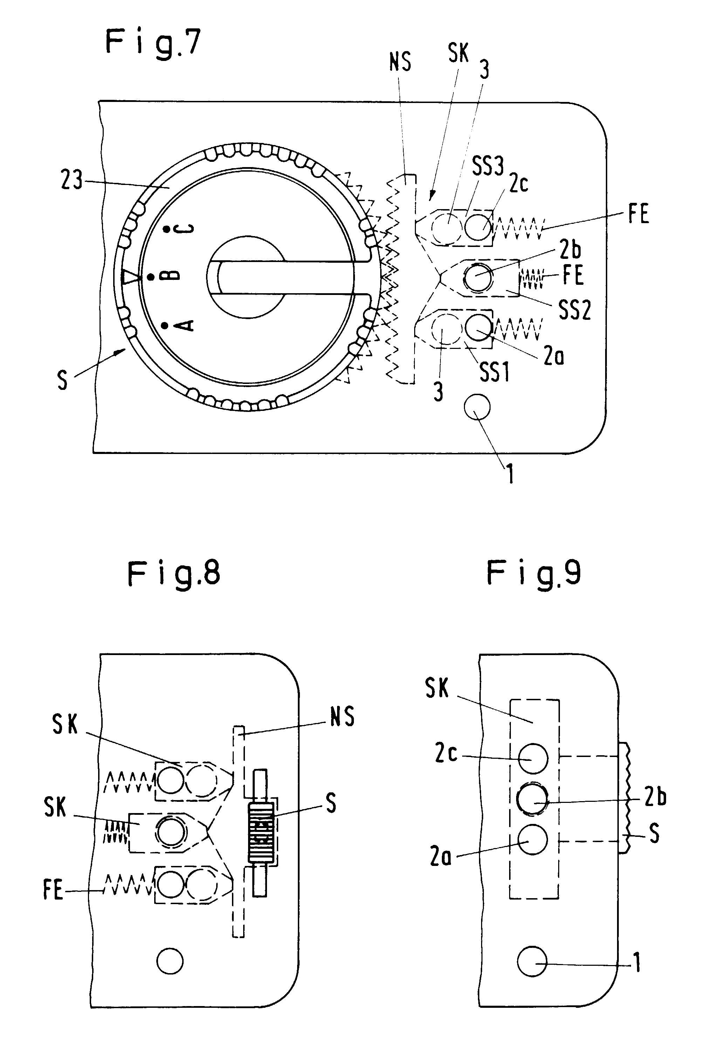

Wie die Fig. 7 bis 9 erkennen lassen, gibt es ein Vielzahl von Lösungsmöglichkeiten, wie eine mit dem Meßbereichsschalter S gekoppelte Sperrkulisse SK, bestimmte Eingangsanschlüsse 2a bis 2c gegenüber einem kontaktierenden Anschließen von Meßleitungen sperren oder freigeben kann. So ist in Fig. 7 die Sperrkulisse SK mit Hilfe von drei Sperrschiebern SS1 bis SS3 aufgebaut, von denen jeder mit Hilfe einer Feder FE in einer Sperrstellung gehalten wird, aus der er nur durch einen Nockenschieber NS verdrängt werden kann, und dann in eine Freigabestellung gelangt. Im vorliegenden Beispiel sorgt der Nockenschieber NS dafür, daß der Sperrschieber SS2 mit seiner Aussparung 3 den Eingangsanschluß 2b freigibt. Dieser Eingangsanschluß 2b ist der am Meßbereichsschalter S eingestellten Meßgröße B zugeordnet.

Die Wirkungsweise der Sperrkulisse nach Fig. 8 entspricht der von Fig. 7, wobei der Nockenschieber NS lediglich durch einen geradlinig bewegten, als Schiebeschalter ausgebildeten Meßbereichsschalter S angetrieben wird und nicht wie in Fig. 7 durch einen drehbaren Meßbereichsschalter S.

Fig. 9 zeigt, daß das zum Meßbereichsschalter S gehörige Betätigungsteil nicht zwingend auf der Bedienfläche, sondern selbstverständlich auch an einer der Seitenflächen des Meßgerätegehäuses angebracht sein kann. Bei diesem Beispiel wird eine Sperrkulisse besonders einfacher Art verwendet, da ihre geradlinige Verschiebung unmittelbar mit der geradlinigen Anordnung der Eingangsanschlüsse 2a bis 2c korrespondiert.

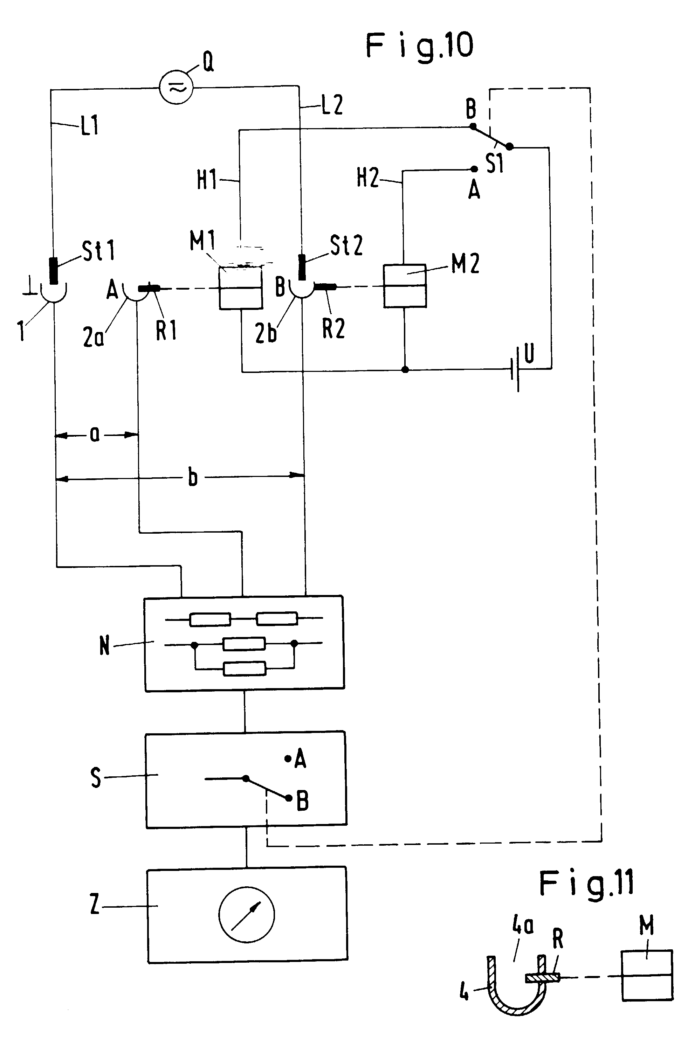

Die Fig. 10 und 11 lassen erkennen, daß die Sperrung bestimmter Eingangsanschlüsse 2a,2b auch mit Hilfe eines elektromagnetisch betätigte Sperriegels R möglich ist. Fig. 10 läßt die Kopplung des Meßbereichsschalters S mit zwei Hilfskreisen H1,H2 erkennen, in denen jeweils ein Magnetsteller M1, M2 angeordnet ist, der jeweils über einen Sperriegel R1,R2 den zugehörigen Eingangsanschluß 2a,2b gegenüber dem kontaktierenden Anschließen einer Meßleitung L2 mit dem Stecker ST2 sperren kann. Beim vorliegenden Beispiel ist der Meßbereichsschalter S mit einer zusätzlichen Schaltstrecke S1 versehen, die entsprechend der durch den Meßbereichsschalter S vorgegebenen Auswahl der Meßgröße B, die gleichzeitig auch dem Eingangsanschluß 2a zugeordnet ist, den Hilfskreis H1 mit einer Spannungsquelle U verbindet und dadurch den Magnetsteller M1 aktiviert, der seinerseits mit dem Sperriegel R1 den Eingangsanschluß 2a sperrt. Ausgehend von dem als Spannungsquelle dargestellten Meßobjekt Q können somit die mit den Steckern ST1, ST2 versehenen Meßleitungen L1,L2 nur den gemeinsamen Eingangsanschluß 1 und den der Meßgröße B1 zugeordneten Eingangsanschluß 2b kontaktieren und damit den Eingangskreis b schließen. Über ein mit dem Meßbereichsschalter S verbundenes Meßbereichsnetzwerk N, das sich nach Art und Aufbau nach der jeweiligen Meßgröße richten muß, gelangt das Meßsignal zu dem eigentlichen Meßsystem Z, das für die Auswertung und Anzeige des Meßsignals sorgt. Nach einem Umschalten des Meßbereichsschalters S auf die Meßgröße A würde der Magnetsteller M1 den zugehörigen Sperriegel R1 wieder in die Ausgangsstellung zurückziehen und damit den Eingangsanschluß für die Meßgröße A freigeben, während der zweite Magnetsteller M2 nunmehr ativiert würde und über den zweiten Sperriegel R2 den Eingangsanschluß 2b sperren würde.

Fig. 11 soll die als Steckbuchse 4 ausgebildeten Eingangsanschlüsse 2a,2b mit dem durch einen Magnetsteller M angetriebenen Sperriegel R verdeutlichen, der den Aufnahmekanal 4a der Steckbuchse 4 gegenüber einer Kontaktierung schließt.

## Patentansprüche

1. Multimeter mit einem Gehäuse (20), bestehend aus mehreren Wandungen (21, 21a) mit mindestens drei, vorzugsweise als Steckbuchsen ausgeführten Eingangsanschlüssen (1, 2a - 2c) zum Anschließen von zwei Meßleitungen (L1, L2), von denen mindestens eine beim Wechsel einer zu untersuchenden Meßgröße (A - C), mit einem anderen, dieser neuen Meßgröße (A - C) zugeordneten Eingangsanschluß (1, 2a - 2c) zu verbinden ist, und mit einem Meßbereichsschalter (S), der in eine der gewählten Meßgröße (A - C) zugeordnete Schaltstellung zu bringen ist,
**dadurch gekennzeichnet,**
daß mit dem Meßbereichsschalter (S) eine elektrisch und/oder mechanisch wirkende Sperrvorrichtung (R,SK) gekoppelt ist, die eine Sperrung bestimmter Eingangsanschlüsse (1, 2a - 2c) in einer Weise erlaubt, daß eine über die Meßleitungen (L1, L2) ein Meßsignal aufnehmende Kontaktierung nur jeweils der Eingangsanschlüsse (1, 2a - 2c) erfolgen kann, denen eine Meßgröße (A - C) zugeordnet ist, die der mit dem Meßbereichsschalter (S) eingestellten Meßgröße (A - C) entspricht.

2. Multimeter nach Anspruch 1,
**dadurch gekennzeichnet,**
daß die Sperrvorrichtung (R, SK) als eine mit dem Meßbereichsschalter (S) verbundene Sperrkulisse (SK) ausgeführt ist, deren Lage sich bei Betätigung des Meßbereichsschalters (S) bezüglich der Eingangsanschlüsse (1, 2a - 2c) so ändert, daß sie eine Kontaktierung bestimmter Eingangsanschlüsse (1, 2a - 2c) durch die vorzugsweise als Stecker (Stl, St2), ausgeführten Kontaktteile der Meßleitungen (L1, L2) verhindert, und der Meßbereichsschalter (S) bei angeschlossenen Meßleitungen (L1, L2) nicht auf den Meßbereich einer anderen Meßgröße (A - C) umschaltbar ist.

3. Multimeter nach Anspruch 2,
**dadurch gekennzeichnet,**
daß die Sperrkulisse (SK) aus Isoliermaterial besteht und den Aufnahmekanal (4a) mindestens eines der als Steckbuchsen (4) ausgeführten Eingangsanschlüsse (1, 2a - 2c) quer zur Steckrichtung soweit blockiert, daß ein kontaktierendes Einführen eines Steckers (St1, St2) ausgeschlossen ist, solange sich die Sperrkulisse (SK) für den jeweiligen Eingangsanschluß (2a - 2d) in Sperrstellung befindet.

4. Multimeter nach einem der vorhergehenden Ansprüche 2 oder 3,
**dadurch gekennzeichnet,**
daß die Sperrkulisse (SK) der Art und dem Aufbau des zugehörigen Meßbereichsschalters (S) angepaßt ist und vorzugsweise eine Dreh- oder Schiebekulisse zur Anwendung kommt und in der Sperrkulisse (SK) mindestens eine Aussparung (3) vorgesehen ist, deren Positionierung mit der Schaltstellung des Meßbereichsschalters so korrespondiert, daß die Aussparungen (3a - 3c) jeweils den Aufnahmekanal (4a) des als Steckbuchse (4) ausgebildeten Eingangsanschlusses (1, 2a - 2c) freigeben, der mit dem Meßbereichsschalter (S) eingestellten Meßgröße (A, C) zugeordnet ist.

5. Multimeter nach einem der Ansprüche 2 - 4,
**dadurch gekennzeichnet,**
daß die Sperrkulisse (SK) im Bereich der Eingangsanschlüsse (1, 2a - 2c) mindestens einen Eingangsanschluß (2a - 2c) nach außen abdeckend, in einer zu ihrer Aufnahme und Lagerung vorgesehenen Ausnehmung (22) einer der Wandungen (21a) des Gehäuses (20) beweglich angeordnet ist und ein von Hand betätigbares Betätigungsteil (5) des Meßbereichsschalters (S), vorzugsweise ein dazugehöriges Schalterrad (5a), so auf die Sperrkulisse (SK) einwirkt, daß diese ihre Lage zu den Eingangsanschlüssen (1, 2a -2c) entsprechend ändert.

6. Multimeter nach Anspruch 5,
**dadurch gekennzeichnet,**
daß das Betätigungsteil (5) des Meßbereichsschalters (S) in der gleichen oder einer parallel versetzten Ebene wie die als drehbewegliches Element ausgebildete Sperrkulisse (SK) angeordnet ist und über Kupplungselemente (5c, 25) ein gegenseitiger Eingriff stattfindet, der zumindest in einem Teilbereich einer vom Betätigungsteil (5) ausführbaren Drehbewegung die zwangsweise Mitnahme der Sperrkulisse (SK) bewirkt.

7. Multimeter nach einem der vorhergehenden Ansprüche 5 oder 6,
**dadurch gekennzeichnet,**
daß das Schalterrad (5a) ein erstes Kupplungselement (24) besitzt, mit dem es an mindestens einem zweiten Kupplungselement (25) der drehbeweglichen Sperrkulisse (SK) eingreifen kann.

8. Multimeter nach Anspruch 7,
**dadurch gekennzeichnet,**
daß das erste Kupplungselement (24) als mindestens ein Zapfen und das zweite Kupplungselement als zweizinkige Gabel nach Art eines Malteserkreuzgetriebes ausgebildet sind.

9. Multimeter nach Anspruch 8,
**dadurch gekennzeichnet,**
daß die Gabel (25) so ausgebildet ist, daß der Zapfen (5c) des Schalterrades (5a) in eine Führungsnut (25c) der Gabel (25) hinein und in entgegengesetzter Drehrichtung aus dieser wieder heraus gleitet.

10. Multimeter nach Anspruch 9,
**dadurch gekennzeichnet,**
daß die zwangsweise Kupplung nur in einem Teil des Drehbereichs des Schalterrades (5a) aufrechterhalten wird, derart, daß das Schalterrad (5a) bis zu einem den Drehbereich begrenzenden Anschlag weitergedreht werden kann, sobald der Zapfen (5c) die Führungsnut (25c) der Gabel (25) verlassen hat, während die Sperrkulisse (SK) nunmehr in Ruhestellung verharrt.

11. Multimeter nach einem der Ansprüche 5 - 10,
**dadurch gekennzeichnet,**
daß ein Freilauf des Schalterrades (5a) gegenüber der Sperrkulisse (SK) jeweils dort vorgesehen ist, wo mehrere Meßbereiche (A, A1, A2) demselben Eingangsanschluß (2a) zugeordnet sind.

12. Multimeter nach einem der Ansprüche 2 - 11,
**dadurch gekennzeichnet,**
daß die Sperrkulisse (SK) eine als Langloch ausgebildete Aussparung (3) besitzt, die den bei der Drehung entstehenden Versatz gegenüber den auf einer Geraden liegenden Eingangsanschlüssen (2a - 2c) ausgleicht und bei entsprechender Positionierung jeweils einen Eingangsanschluß (2a - 2c) freigibt.

13. Multimeter nach einem der Ansprüche 2 - 12,
**dadurch gekennzeichnet,**
daß die Sperrkulisse (SK) aus einzelnen Sperrschiebern (SS1 - SS3) aufgebaut ist, von denen jeder so gelagert ist, daß er durch eine Verschiebung gegen die Kraft einer ihn in Ruhestellung haltenden Feder (FE) durch einen vom Meßbereichsschalter (S) angetriebenen Nockenschieber (NS) in eine den Eingangsanschluß (2a - 2b) sperrende Stellung zu bringen ist.

14. Multimeter nach Anspruch 1,
**dadurch gekennzeichnet,**
daß mindestens einer der Eingangsanschlüsse (1, 2a - 2d), die als Steckbuchsen (4) ausgebildet sind, ein elektromagnetisch zu betätigendes Sperrelement (R1, R2) besitzt, das so angeordnet ist, daß es eine Kontaktierung verhindernde Sperrstellung annehmen kann, indem es den Aufnahmekanal (4a) einer Steckbuchse (4) blockiert, wenn die am Meßbereichsschalter (S) eingestellte Meßgröße mit der dem Eingangsanschluß (2a - 2d) zugeordneten Meßgröße (A - D) nicht übereinstimmt, wobei die Auslösung der elektromagnetischen Betätigung des Sperrelements (R1, R2) über mindestens eine Schaltstrecke (S1) des Meßbereichsschalters (S) erfolgt.

## Claims

1. Multimeter, having a housing (20), comprising a plurality of walls (21, 21a) with at least three input connections (1, 2a - 2c), preferably in the form of plug sockets, for the connection of two measuring lines (L1, L2), of which at least one, when there is a change in a measuring parameter (A - C) to be tested, is to be connected to another input connection (1, 2a - 2c) associated with this new measuring parameter (A - C) and with a measuring range switch (S), which is to be brought into a switching position associated with the selected measuring parameter (A - C), characterised in that, coupled with the measuring range switch (S), there is an electrically and/or mechanically operating locking device (R, SK) which permits a locking of predetermined input connections (1, 2a - 2c) in such a manner that a contact, receiving a measuring signal via the measuring lines (L1, L2), can be achieved between only the respective input connections (1, 2a - 2c) with which a measuring parameter (A - C), corresponding to the measuring parameter (A - C) set by the measuring range switch (S), is associated.

2. Multimeter according to claim 1, characterised in that the locking device (R, SK) is configured as a locking detent (SK) connected to the measuring range switch (S), the position of said detent changing with respect to the input connections (1, 2a - 2c), when the measuring range switch (S) is actuated, in such a manner that it prevents a contact being formed between predetermined input connections (1, 2a - 2c) by means of the contact members of the measuring lines (L1, L2), which members are preferably configured as plugs (St1, St2), and the measuring range switch (S) cannot be changed-over to the measuring range of another measuring parameter (A - C) when the measuring lines (L1, L2) are connected.

3. Multimeter according to claim 2, characterised in that the locking detent (SK) is formed from insulating material, and at least one of the input connections (1, 2a - 2c), configured as plug sockets (4), blocks the receiving channel (4a) transversely relative to the plug-in direction to such an extent that the contact-making insertion of a plug (St1, St2) is prevented so long as the locking detent (SK) is in the locking position for the respective input connection (2a - 2d).

4. Multimeter according to one of the preceding claims 2 or 3, characterised in that the locking detent (SK) is adapted to the type and the structure of the associated measuring range switch (S), and a rotating or sliding detent is preferably used, and at least one recess (3) is provided in the locking detent (SK), the positioning of said recess corresponding to the switching position of the measuring range switch so that the recesses (3a - 3c) each expose the respective receiving channel (4a) of the input connection (1, 2a - 2c), which is configured as plug socket (4) and is associated with the measuring parameter (A, C) set by the measuring range switch (S).

5. Multimeter according to one of claims 2 - 4, characterised in that the locking detent (SK) is disposed in the region of the input connections (1, 2a - 2c) and so as to be displaceable in one recess (22), provided for the accommodation and mounting of said detent, in one of the walls (21a) of the housing (20), so as to cover at least one input connection (2a - 2c) outwardly, and a manually actuatable actuating member (5) of the measuring range switch (S), preferably a switch wheel (5a) associated therewith, acts upon the locking detent (SK) in such a manner that said detent changes its position relative to the input connections (1, 2a - 2c) accordingly.

6. Multimeter according to claim 5, characterised in that the actuating member (5) of the measuring range switch (S) is disposed in the same plane as, or in an offset parallel plane to, the locking detent (SK) configured as a rotatable element, and a reciprocal engagement occurs via coupling elements (5c, 25), which engagement causes the compulsory entrainment of the locking detent (SK) in at least one partial region of a rotational movement, which can be accomplished by the actuating member (5).

7. Multimeter according to one of the preceding claims 5 or 6, characterised in that the switch wheel (5a) has a first coupling element (24), with which it can engage on at least a second coupling element (25) of the rotatable locking detent (SK).

8. Multimeter according to claim 7, characterised in that the first coupling element (24) is configured as at least one pin, and the second coupling element is configured as a two-pronged fork in the form of a Maltese cross transmission.

9. Multimeter according to claim 8, characterised in that the fork (25) is so configured that the pin (5c) of the switch wheel (5a) slides into a guide groove (25c) of the fork (25) and slides out again therefrom in the opposite direction of rotation.

10. Multimeter according to claim 9, characterised in that the compulsory coupling is maintained only in one portion of the rotatable region of the switch wheel (5a), so that the switch wheel (5a) can be further rotated as far as a stop member, which defines the rotatable region, as soon as the pin (5c) has left the guide groove (25c) of the fork (25), while the locking detent (SK) now remains in its inoperative position.

11. Multimeter according to one of claims 5 - 10, characterised in that a free-wheeling movement of the switch wheel (5a) relative to the locking detent (SK) is provided wherever a plurality of measuring ranges (A, A1, A2) are associated with the same input connection (2a).

12. Multimeter according to one of claims 2 - 11, characterised in that the locking detent (SK) has a recess (3) configured as an elongate slot, which recess compensates for the offset arrangement, produced during the rotation, relative to the input connections (2a - 2c) lying on a straight line and exposes a respective input connection (2a - 2c) by appropriate positioning.

13. Multimeter according to one of claims 2 - 12, characterised in that the locking detent (SK) is constructed from individual locking slides (SS1 - SS3), each of which is mounted so that it is to be brought into a position, which locks the input connection (2a - 2b), by means of a displacement in opposition to the force of a spring (FE), which keeps said slide in the inoperative position, by a cam slide (NS) driven by the measuring range switch (S).

14. Multimeter according to claim 1, characterised in that at least one of the input connections (1, 2a - 2d), which are configured as plug sockets (4), has an electromagnetically actuatable locking element (R1, R2), which is so disposed that it can assume a contact-preventing locking position by blocking the receiving channel (4a) of a plug socket (4) when the measuring parameter, set at the measuring range switch (S), is not identical to the measuring parameter (A - D) associated with the input connection (2a - 2d), the release of the electromagnetic actuation of the locking element (R1, R2) being effected via at least one switching path (S1) of the measuring range switch (S).

## Revendications

1. Contrôleur universel pourvu d'un boîtier (20) qui est constitué par plusieurs parois (21, 21a), comprenant au moins trois raccords d'entrée (1, 2a à 2c) qui sont réalisés de préférence sous la forme de fiches femelles, qui sont destinés au raccordement de deux conducteurs de mesure (L1, L2) dont un au moins, lors du changement de la grandeur à mesurer (A à C) qu'il s'agit de contrôler, doit être relié à un autre raccord d'entrée (1, 2a à 2c) associé à cette nouvelle grandeur à mesurer (A à C), et comprenant un sélecteur de gammes (S) qui doit être amené dans une position de commutation associée à la grandeur à mesurer choisie (A à C), caractérisé par le fait qu'est accouplé au sélecteur de gammes (S) un dispositif de blocage (R, SK) à action mécanique et/ou électrique qui permet un blocage de raccords d'entrée déterminés (1, 2a à 2c) d'une manière telle qu'une mise en contact de réception d'un signal de mesure par l'intermédiaire des conducteurs de mesure (L1, L2) ne peut avoir lieu à chaque fois que sur les raccords d'entrée (1, 2a à 2c) auxquels est associée une grandeur à mesurer (A à C) correspondant à la grandeur à mesurer (A à C) qui a été réglée au moyen du sélecteur de gammes (S).

2. Contrôleur universel selon la revendication 1, caractérisé par le fait que le dispositif de blocage (R, SK) est réalisé sous la forme d'une plaque mobile de blocage (SK) qui est reliée au sélecteur de gammes (S) et dont la position par rapport aux raccords d'entrée (1, 2a à 2c) change lors de l'actionnement du sélecteur de gammes (S) de manière à empêcher une mise en contact de raccords d'entrée déterminés (1, 2a à 2c) avec les organes de contact des conducteurs de mesure (L1, L2) qui sont réalisés de préférence sous la forme de fiches mâles (St1, St2), et d'une manière telle que le sélecteur de gammes (S) ne puisse pas être amené sur la gamme de mesure d'une autre grandeur à mesurer (A à C) lorsque les conducteurs de mesure (L1, L2) sont raccordés.

3. Contrôleur universel selon la revendication 2, caractérisé par le fait que la plaque mobile de blocage (SK) est constituée par une matière isolante, et qu'elle bloque, transversalement par rapport à la direction d'enfoncement, le canal formant logement (4a) de l'un au moins des raccords d'entrée (1, 2a à 2c) qui sont réalisés sous la forme de fiches femelles (4), et ce, d'une manière telle qu'une introduction avec contact d'une fiche mâle (St1, St2) soit exclue aussi longtemps que la plaque mobile de blocage (SK) se trouve en position de blocage pour le raccord d'entrée correspondant (2a à 2c).

4. Contrôleur universel selon l'une des revendications précédentes 2 et 3, caractérisé par le fait que la plaque mobile de blocage (SK) est adaptée au type et à la construction du sélecteur de gammes associé (S), que l'on utilise de préférence une plaque mobile tournante ou coulissante, et qu'il est prévu dans la plaque mobile de blocage (SK) au moins un évidement (3) dont le positionnement correspond à la position de commutation du sélecteur de gammes d'une manière telle que les évidements (3a à 3c) libèrent à chaque fois le canal formant logement (4a) du raccord d'entrée (1, 2a à 2c) qui est associé à la grandeur à mesurer (A à C) réglée par le sélecteur de gammes (S) et qui est réalisé sous la forme d'une fiche femelle (4).

5. Contrôleur universel selon l'une des revendications 2 à 4, caractérisé par le fait que la plaque mobile de blocage (SK) est disposée en étant mobile dans la région des raccords d'entrée (1, 2a à 2c) et en recouvrant vers l'extérieur au moins un raccord d'entrée (2a à 2c) dans un évidement (22) de l'une (21a) des parois du boîtier (20) qui est prévu pour la recevoir et la monter, et qu'une partie d'actionnement (5) du sélecteur de gammes (S) qui est de préférence une roue de commutation (5a) associée à ce dernier et qui peut être actionnée à la main agit sur la plaque mobile de blocage (SK) d'une manière telle que celle-ci change en conséquence de position par rapport aux raccords d'entrée (1, 2a à 2c).

6. Contrôleur universel selon la revendication 5, caractérisé par le fait que la partie d'actionnement (5) du sélecteur de gammes (S) est disposée dans le même plan que la plaque mobile de blocage (SK) qui est réalisée sous la forme d'un élément mobile en rotation, ou dans un plan parallèle décalé, et qu'il se produit, par l'intermédiaire d'éléments d'accouplement (5c, 25), une venue en prise mutuelle qui réalise l'entraînement forcé de la plaque mobile de blocage (SK), du moins dans une zone partielle d'un déplacement en rotation pouvant être effectué par la partie d'actionnement (5).

7. Contrôleur universel selon l'une des revendications précédentes 5 et 6, caractérisé par le fait que la roue de commutation (5a) comporte un premier élément d'accouplement (24) au moyen duquel elle peut venir en prise avec au moins un deuxième élément d'accouplement (25) de la plaque mobile de blocage (SK) qui est mobile en rotation.

8. Contrôleur universel selon la revendication 7, caractérisé par le fait que le premier élément d'accouplement (24) est réalisé sous la forme d'au moins un goujon, et que le deuxième élément d'accouplement l'est sous la forme d'une fourche à deux dents à la manière d'un mécanisme à croix de Malte.

9. Contrôleur universel selon la revendication 8, caractérisé par le fait que la fourche (25) est réalisée d'une manière telle que le goujon (5c) de la roue de commutation (5a) glisse en entrant dans une rainure de guidage (25c) de la fourche (25) et en sortant à nouveau de celle-ci dans la direction de rotation opposée.

10. Contrôleur universel selon la revendication 9, caractérisé par le fait que l'accouplement forcé n'est conservé que dans une partie de la zone de rotation de la roue de commutation (5a), d'une manière telle que l'on puisse continuer à faire tourner la roue de commutation (5a) jusqu'à une butée qui délimite la zone de rotation aussitôt que le goujon (5c) a quitté la rainure de guidage (25c) de la fourche (25), tandis que la plaque mobile de blocage (SK) reste alors dans la position de repos.

11. Contrôleur universel selon l'une des revendications 5 à 10, caractérisé par le fait qu'une course libre de la roue de commutation (5a) par rapport à la plaque mobile de blocage (SK) est prévue à chaque fois lorsque plusieurs gammes de mesure (A, A1, A2) sont associées au même raccord d'entrée (2a).

12. Contrôleur universel selon l'une des revendications 2 à 11, caractérisé par le fait que la plaque mobile de blocage (SK) présente un évidement (3) qui est réalisé sous la forme d'un trou allongé, qui compense le décalage prenant naissance lors de la rotation par rapport aux raccords d'entrée (2a à 2c) situés sur une droite et qui libère à chaque fois un raccord d'entrée (2a à 2c) pour un positionnement correspondant.

13. Contrôleur universel selon l'une des revendications 2 à 12, caractérisé par le fait que la plaque mobile de blocage (SK) est constituée par des coulisseaux de blocage individuels (SS1 à SS3) dont chacun est monté de manière à pouvoir être amené dans une position bloquant le raccord d'entrée (2a à 2c) par un coulissement, à l'encontre de la force d'un ressort (FE) qui le maintient dans sa position de repos, au moyen d'un coulisseau à came (NS) entraîné par le sélecteur de gammes (S).

14. Contrôleur universel selon la revendication 1, caractérisé par le fait que l'un au moins des raccords d'entrée (1, 2a à 2c) qui sont réalisés sous la forme de fiches femelles (4) comporte un élément de blocage à actionnement électromagnétique (R1, R2), celui-ci étant disposé d'une manière telle qu'il puisse prendre une position de blocage empêchant une venue en contact en bloquant le canal formant logement (4a) d'une fiche femelle (4) lorsque la grandeur à mesurer déterminée par le sélecteur de gammes (S) ne coïncide pas avec la grandeur à mesurer (A à C) associée au raccord d'entrée (2a à 2c), cependant que le déclenchement de l'actionnement électromagnétique de l'élément de blocage (R1, R2) a lieu par l'intermédiaire d'au moins une voie de commutation (S1) du sélecteur de gammes (S).
